# EUROPEAN PATENT APPLICATION

(11) **EP 4 254 501 A1**
(43) Date of publication of application: **04.10.2023**
(21) Application number: 22166131.7
(22) Date of filing: 31.03.2022
(51) Int. Cl.: H01L 27/146

(54) **A PIXEL UNIT WITH INFRARED ABSORBER, A PIXEL ARRAY, AND A CAMERA IMPLEMENTING SUCH A PIXEL ARRAY**

(71) Applicant: Sony Semiconductor Solutions Corporation, Atsugi-shi Kanagawa 243-0014 (JP); Politecnico Di Torino, 10129 Torino (IT)
(72) Inventor: RIVERO CAMPOS, Francisco Javier, 10129 Torino (IT); TOBON VASQUEZ, Jorge Alberto, 10129 Torino (IT); VIPIANA, Francesca, 10129 Torino (IT); AMAYA BENITEZ, Manuel, 70327 Stuttgart (DE); UENO, Takahisa, 70327 Stuttgart (DE)
(74) Representative: MFG Patentanwälte Meyer-Wildhagen Meggle-Freund Gerhard PartG mbB

(57) **Abstract**

A backside-illuminated pixel comprising a photodiode (301) and an infrared absorber (301) with embedded nanostructure (402, 403), wherein the infrared absorber (301) with embedded nanostructure (401, 402) is configured to absorb light (305) that passes the photodiode (301).

## Description

### TECHNICAL FIELD

The present disclosure generally pertains to the field of imaging sensors, and in particular to cameras and electronic devices using such sensors.

### TECHNICAL BACKGROUND

Pixels of an imaging sensors are typically based on semiconductor technology. In a semiconductor, free charge carriers, such as electron-hole pairs are created by excitation of electron from valence band to the conduction band. This excitation leaves a hole in the valence band which behaves as positive charge, and an electron-hole pair is created. The hole (i.e. positive charge) moves toward the anode connection of the circuit, and the excited electrons are attracted to the cathode connection. A photocurrent is thus generated.

The non-converted incident light in the photodiode may cause reflections that produce undesirable artifacts in the neighbouring pixels, such as cross-talk.

Therefore, it is generally desirable to reduce artifacts and to improve a pixel's response to the incident light as far as possible.

### SUMMARY

According to a first aspect, the disclosure provides a backside-illuminated pixel comprising a photodiode and an infrared absorber with embedded nanostructure, wherein the infrared absorber with embedded nanostructure is configured to absorb light that passes the photodiode.

According to a further aspect, the disclosure provides a sensor device comprising a pixel array, the pixel array comprising multiple backside-illuminated pixels as defined above.

According to a further aspect, the disclosure provides a ToF camera comprising the sensor device as defined above.

Further aspects are set forth in the dependent claims, the following description, and the drawings.

### BRIEF DESCRIPTION OF THE DRAWINGS

Embodiments are explained by way of example with respect to the accompanying drawings, in which:
Fig. 1 schematically shows, in a cross-sectional view in the x-z-plane, a backside-illuminated IR pixel having a metallization layer and a logic;
Fig. 2 schematically shows, in a cross-sectional view in the x-z-plane, a backside-illuminated IR pixel having a metallization layer, a logic, and an infrared absorbing layer;
Fig. 3 schematically shows, in a cross-sectional view in the x-z-plane, a backside-illuminated IR pixel having a metallization layer and an infrared absorbing layer with nanostructures;
Fig. 4 schematically shows, in a top view of the x-z-plane, an arrangement of nanostructures of in a nanostructure array with periodic cell structure;
Fig. 5 schematically shows, in a top view of the x-z-plane, an example of an infrared absorber with embedded nanostructures of elliptical shape in an array with periodic cell structure, as it may be comprised in the backside-illuminated pixel of Fig. 3;
Fig. 6 schematically shows, in a top view of the x-z-plane, a cell of the nanostructure array of Fig. 5 (see 504 in Fig. 5);
Fig. 7 schematically shows a front view of the x-z-plane of the nanostructure cell of Fig. 6;
Fig. 8 schematically shows, in a cross-sectional view in the x-z-plane, a backside-illuminated pixel having a metallization layer, an infrared absorbing layer with embedded nanostructure, and a fill trench isolation (FTI) at the border to adjacent pixels;
Fig. 9 schematically shows, in a cross-sectional view in the x-z-plane, a backside-illuminated pixel having a metallization layer, an infrared absorbing layer with embedded nanostructure, and a deep trench isolation (DTI) at the border to adjacent pixels;
Fig. 10 schematically shows, in a cross-sectional view of the x-z-plane, a structure of a backside-illuminated pixel array with additional IR absorber arranged above the photodiode array;
Fig. 11 schematically shows, in a top view of the x-z-plane, the structure of a backside-illuminated pixel array of Fig. 10;
Fig. 12a shows an exemplifying configuration of an infrared absorber with an embedded nanostructure optimized for absorption at 940 nm wavelength;
Fig. 12b shows a contour plot of the relative reflected power density at a transversal-cut surface located at 240 nm above the inserted nanostructure for the configuration of Fig. 12a (240 nm t²_{SiO2});
Fig. 13a shows an exemplifying configuration of an infrared absorber with an embedded nanostructure optimized for absorption at 1380 nm wavelength;
Fig. 13b shows a contour plot of the relative reflected power density at a transversal-cut surface located at 190 nm above the inserted nanostructure for the configuration of Fig. 13a (190 nm t²_{SiO2});
Fig. 14a shows an exemplifying configuration of an infrared absorber with an embedded nanostructure optimized for absorption at 1550 nm wavelength;
Fig. 14b shows a contour plot of the relative reflected power density at a transversal-cut surface located at 190 nm above the inserted nanostructure for the configuration of Fig. 14a (190 nm t²_{SiO2});
Fig. 15 illustrates in a diagram absorption vs wavelength the performance of a nanostructure IR absorber as described in the embodiments above; and
Fig. 16 illustrates in diagram the Width band Minimum Absorption (WMA) as described with regard to Fig. 15 above.

### DETAILED DESCRIPTION OF EMBODIMENTS

Before a detailed description of the embodiments under reference of the figures, some general explanations are made.

The embodiments disclose a backside-illuminated pixel comprising a photodiode and an infrared absorber with embedded nanostructure, wherein the infrared absorber with embedded nanostructure is configured to absorb light that passes the photodiode.

The backside-illuminated pixel may for example be applied in IR imaging, IR Time-of Flight (ToF), and IR sensing.

For example, include a nanostructure above the metallization layer of backside-illuminated pixels may avoid the reflection of infrared (IR) light in the metallization layer. This may prevent undesirable effects, e.g. crosstalk. An infrared absorber with embedded nanostructure may in particular be helpful for infrared imaging and ToF (time-of-flight) pixels. It may however be also used in other sensing pixels where leaked infrared light produces undesirable side effects (e.g., cross-talk).

The infrared absorber with embedded nanostructure may constitute a metamaterial that is engineered to have a light absorbing property that is not found in naturally occurring materials. A metamaterial may be an assembly of multiple structures fashioned from composite materials with different electromagnetic properties, e.g. metals, semiconductors, and/or dielectrics. The infrared absorber of the embodiments is a metamaterial. A metamaterial may for example be a combination of different materials, formed by layers and/or structures, that results in a "new" material with properties you cannot find in nature.

According to some embodiments, the embedded nanostructure provides a metasurface absorbing light.

The infrared absorber may have a multilayer structure comprising a first layer and a second layer arranged below the first layer, and wherein the nanostructure is embedded in the first layer of the multilayer structure.

An infrared absorber of some embodiments consists of two layers of materials and an inserted nanostructure. The combination of layers and nanostructure provides a metasurface with absorption properties.

According to some embodiments, the first layer is made of a material A and the second layer is made of a material B different from the material A, and the nanostructure embedded in the first layer is made of the same material as the second layer.

Embedding a nanostructure cell in the layer made of the material A, followed by a second layer made of the material B may allow for a resonance that absorbs a desired wavelength.

The material A may for example be a dielectric, and the material B may for example be a metal.

That is, according to some embodiments, the nanostructure is embedded in the dielectric layer, and the nanostructure embedded in the dielectric layer, together with the metal layer represents the absorber, i.e., the dielectric layer, the inserted nanostructure and the metal layer form the absorber (e.g. absorber meta-surface).

According to some embodiments, the material A is silicon dioxide, and the material B is aluminum.

The embedded nanostructure may be configured as a nanostructure array having a pattern that is spatially repeated.

A metamaterial is typically arranged in repeating patterns, at scales that are smaller than the wavelengths of the phenomena they influence.

The nanostructure array may for example be structured as a repetition of cells. Such a periodic structure may provide homogenous absorption properties.

For example, the embodiments may use two materials (e.g. dielectric + metal) to create a multilayer structure with a pattern that is spatially repeated with a predefined cell period.

A cell repetition may for example provide symmetrical properties to the nanostructure array.

According to some embodiments, the cell period of the nanostructure array is independent from pixel pitch. That is, it does not necessarily match with the pixel pitch. Independency from the pixel dimensions can for example be achieved by providing an absorber with uniform performance across its surface.

The nanostructure array may comprise structures that are spatially repeated.

In this way, the combination of different layers of materials and an inserted nanostructure array may create a metamaterial that derives its properties not only from the properties of the base materials themselves, but also from their designed structures.

For example, the shape, geometry, size, orientation and arrangement of the structures may give the metamaterial the properties capable of manipulating electromagnetic waves, in particular the property of absorbing or blocking a predefined wavelength or wavelength region. That is, by choosing these characteristics, the absorber can be tuned to optimize the absorption of a specific infrared bandwidth. Also, different combinations of material layers and nanostructures may allow the absorber to be tuned to optimize the absorption of a specific infrared bandwidth. An optimized combination of materials properties, nanostructures and dimensions may optimize the performance of the absorber. The optimization of the resonances may achieve a desire bandwidth of absorption, even when altering the dimensions of the structure in certain range, e.g. typical variations during the fabrication process.

The structures of the nanostructure array may for example be positioned at the cell borders.

According to some embodiments, the structures of the nanostructure array change their orientation in each row of the pattern.

For example, the structures of the nanostructure array may comprise horizontally positioned structures and vertically positioned structures.

The structures of the nanostructure array may have an elliptical shape or quasi-circular shape.

The insertion of a quasi-circular structure in a material A layer, followed by a material B layer may provide a resonance that absorbs a desired wavelength.

The elliptical shape or quasi-circular shape may for example be defined by a smaller diameter and a larger diameter.

The infrared absorber with nanostructure may for example be located above a metallization layer, and the infrared absorber layer with embedded nanostructures may prevent light from reaching the metallization layer. The nanostructure can for example be integrated above the metallization layer of existing pixel designs to improve the pixel performance.

The infrared absorber may for example be configured to absorb light around center wavelengths of 940nm, or 1380nm, or 1550nm.

According to some embodiments, the backside-illuminated pixel is provided with a fill trench isolation at the border to adjacent pixels.

According to some embodiments, the backside-illuminated pixel is provided with a deep trench isolation at the border to adjacent pixels.

The embodiments also disclose a sensor device comprising a pixel array, the pixel array comprising multiple pixels as defined herein. For example, the sensor device may comprise a photodiode array with multiple backside-illuminated pixels as defined herein. The sensor device may for example be a semiconductor detector that measures the effect of incident photons.

The photodiode array may be provided with an additional IR absorber, e.g. as the one presented in this invention, arranged above the photodiode array. This configuration may be used to create a mask in areas of the sensor where it is desired to avoid the IR light to penetrate in areas of the sensor.

The additional IR absorber arranged above of the photodiode array may be configured to provide the functionalities of an anti-flare shield and/or an On Pixel Barrier shield.

The embodiments also disclose a camera device comprising the sensor device with backside-illuminated pixel as described herein. The camera may for example be an IR imaging camera, or a range imaging camera such as a time-of-flight camera (ToF camera). The camera may however also be any other imaging camera, such as an active pixel camera (APS) which benefits from avoiding IR cross-talk.

### Backside-illuminated pixel

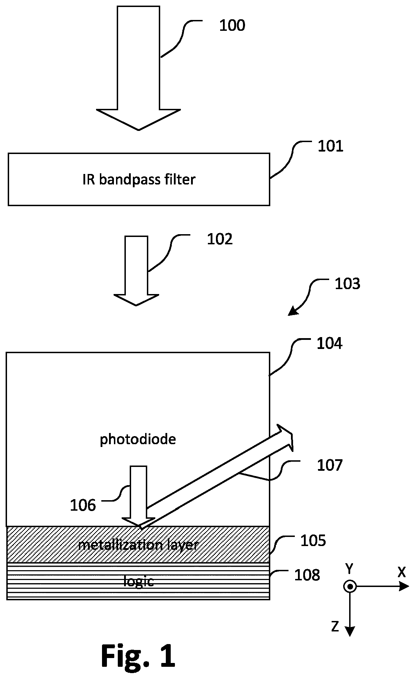

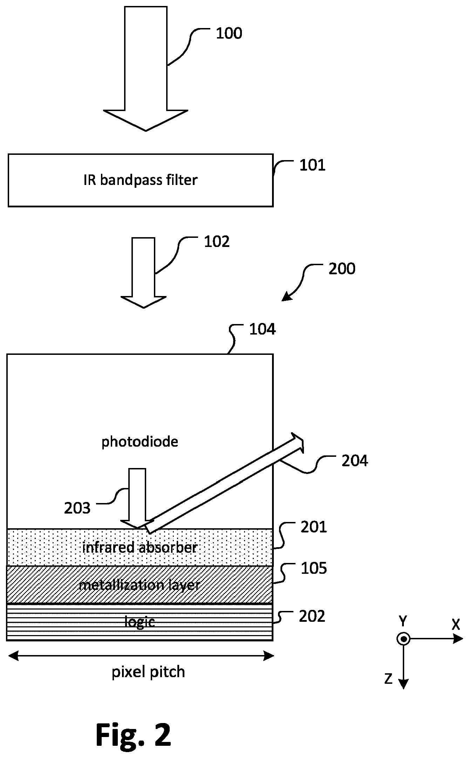

A sensor as described in these embodiments comprises a pixel array comprising a plurality of backside-illuminated pixels, such as the backside-illuminated IR pixel described with regards to Figs. 1 and 2 below.

Fig. 1 schematically shows, in a cross-sectional view in the x-z-plane, a backside-illuminated IR pixel having a metallization layer and a logic. Wide spectrum infrared (IR) light 100, which enters along a z direction, is filtered by an IR bandpass filter 101 to allow only light of a desired wavelength to pass through the IR bandpass filter 101. This filtered light 102 illuminates a backside-illuminated pixel 103. The backside-illuminated pixel 103 comprises a photodiode 104, a metallization layer 105 and a logic 108. The filtered light 102 enters the photodiode 104, and the photodiode 104 converts part of the filtered light 102, into a photocurrent. The non-converted light 106 in the photodiode 104 impacts in the metallization layer 105 producing reflections 107. These reflections 107 may comprise a substantial part of the non-converted light 106 and may cause cross-talk with neighboring pixels, producing undesirable artifacts in these neighboring pixels.

### Backside-illuminated pixel with infrared absorber

Fig. 2 schematically shows, in a cross-sectional view in the x-z-plane, a backside-illuminated IR pixel having a metallization layer, a logic, and an infrared absorbing layer. Wide spectrum IR light 100, which enters along a z direction, is filtered by an IR bandpass filter 101 to allow only light of a desired wavelength to pass through the IR bandpass filter 101. This filtered light 102 illuminates a backside-illuminated pixel 200. The double arrow represents the pixel pitch. The backside-illuminated pixel 200 comprises a photodiode 104 an infrared absorber 201, a metallization layer 105 and a logic 202. Infrared absorber 201 may for example be an infrared absorber layer. The filtered light 102 enters the photodiode 104 and the photodiode 104 converts part of the filtered light 102, into a photocurrent. The non-converted light 203 in the photodiode 104 impacts in the infrared absorber 201 producing reflections 204. The reflections 204 may comprise a substantial part of the non-converted light 203. Reflections 204 may produce cross-talk with neighboring pixels, thereby, producing undesirable artifacts in these neighboring pixels. The reflection 204 may, however, be reduced as compared to the reflections (see 107 in Fig. 1) caused in the backside-illuminated pixel of Fig. 1 (see 103 in Fig. 1) which does not provide an infrared absorber.

### Backside-illuminated pixel with infrared absorber metasurface

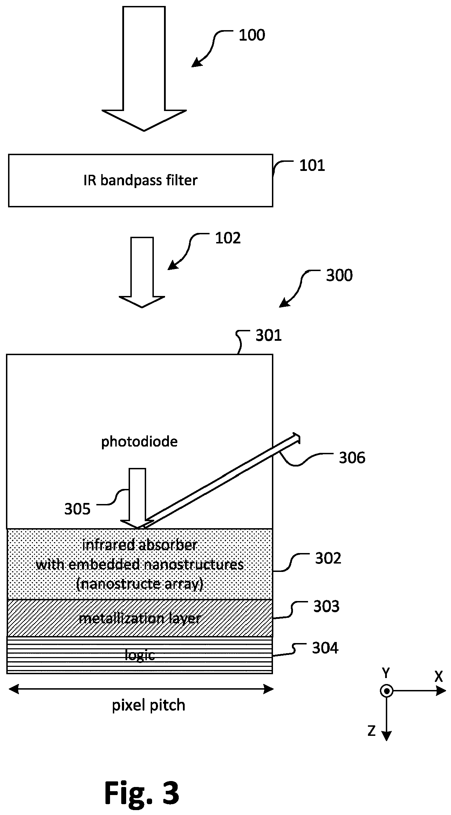

Fig. 3 schematically shows, in a cross-sectional view in the x-z-plane, a backside-illuminated IR pixel having a metallization layer and an infrared absorbing layer with embedded nanostructure. Wide spectrum IR light 100 is filtered by an IR bandpass filter 101 to allow only light of a desired wavelength to pass through the IR bandpass filter 101. The filtered light 102 illuminates a backside-illuminated pixel 300. The backside-illuminated pixel 300 comprises a photodiode 301, an infrared absorber 302, a metallization layer 303 and a logic 304. The filtered light 102 enters the photodiode 301 and the photodiode 301 converts a part of the filtered light 102, into current. The non-converted light 305 in the photodiode 301 impacts in the infrared absorber 302 with embedded nanostructure, producing a reflection 306 of a substantial part of the non-converted light. The double arrow represents the pixel pitch.

In the embodiment of Fig. 3, the infrared absorber 302 comprises an infrared absorber layer including an embedded nanostructure (e.g. the infrared absorber layer with the embedded nanostructure forms a meta-surface). The infrared absorber with embedded nanostructure acts as an infrared absorber metasurface. The infrared absorber 302 with embedded nanostructure prevents most of the light 305 from reaching the metallization layer 303 of the pixel, avoiding reflections that might produce undesirable effects, e.g. crosstalk. As a result of applying an infrared absorber layer with embedded nanostructures, reflections 306 may be significantly reduced as compared to reflections (see 107 in Fig. 1) caused in the backside-illuminated pixel of Figs. 1 and 2 (see 103 in Fig. 1 and 200 in Fig. 2).

The infrared absorber 301 may for example be configured to absorb light at wavelengths of 940nm, or 1380nm, or 1550nm.

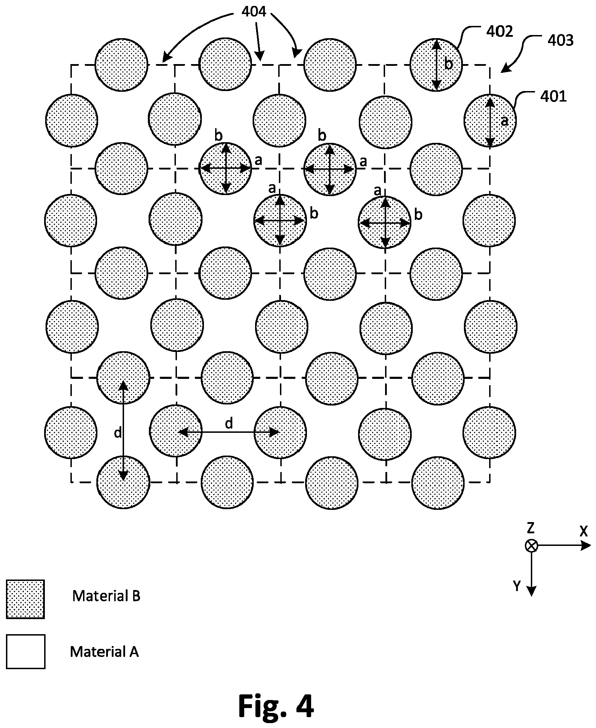

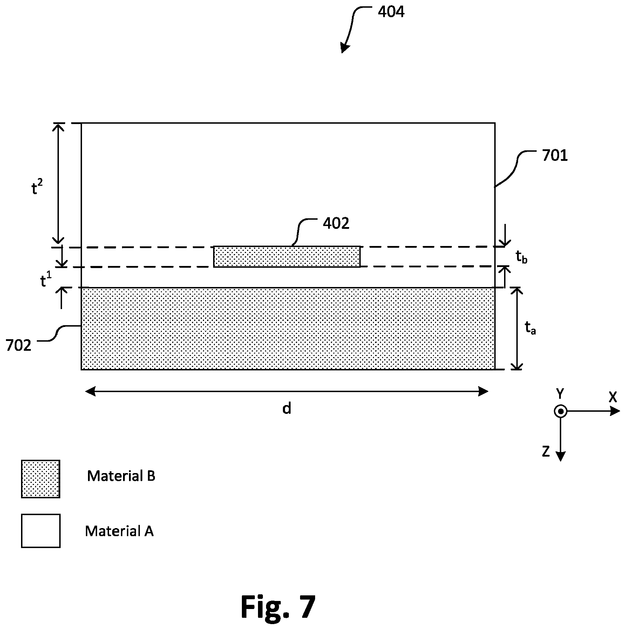

Fig. 4 schematically shows, in a top view of the x-z-plane, a nanostructure array with periodic cell structure as used in infrared absorber of the backside-illuminated pixel of Fig. 3. A nanostructure array 403 comprises structures 401, 402 having a quasi-circular. The nanostructure array 403 has a periodic cell structure. The layer comprising nanostructure array 403 is made of two different materials, e.g. material A and material B, having a pattern that is spatially repeated. The nanostructure 404 comprises structures 401, 402 made of material B. Nanostructure 404 is embedded in a first layer (701 in Fig. 7) of an infrared absorber (302 in Fig. 3) made of material A according to a periodical pattern. The two materials that are used may for example be metal, e.g. aluminum, as material B, and dielectric, e.g. silicon dioxide (SiO₂), as material A.

The nanostructure array 403 is structured as a 4x4 repetition of quadratic cells 404 in the x and y direction, each quadratic cell 404 having a diameter d. That is, the nanostructure cells 404 have a cell period d. The cell repetition in x-direction and y-directions provides symmetrical properties to the nanostructure array 403. The structures 401, 402 are positioned such that their axis are colinear with the borders of the cells 404. Each structure 401, 402 is of quasi-circular shape and has two dimensions a, b. Dimension a relates to a smaller diameter of the shape (i.e. to the minor axis). Dimension b relates to a larger diameter of the shape (i.e. to the major axis).

The bigger axis (major axis) b of the ellipses determines the higher absorption peak of the nanostructure, in term of frequency. The smaller axis (minor axis) a of the ellipses determines the lower frequency of absorption.

The distance between the center of two adjacent structures 402 in the same row is equal to the cell period d and the distance between the center of two adjacent structures 402 in the same column is equal to the cell period d. The dashed grid represents the spatial periodicity d of the nanostructure cells 404. Such a periodic structure may provide homogenous absorption properties. Increasing the periodicity d increases the valley between the absorption peaks.

It should be noted that cell period d is independent from pixel pitch. That is, it does not necessarily match with the pixel pitch.

Optimized absorption may be achieved by an optimized combination of materials properties and dimensions. An absorption layer with the embedded nanostructure array described above may absorb most of the IR light (305 in Fig. 3) before reaching the metallization layer (see 303 in Fig. 3). In particular, an absorber with the embedded nanostructure may be tuned to optimize the absorption of a specific infrared bandwidth and to allow the use of different combinations of material A and B.

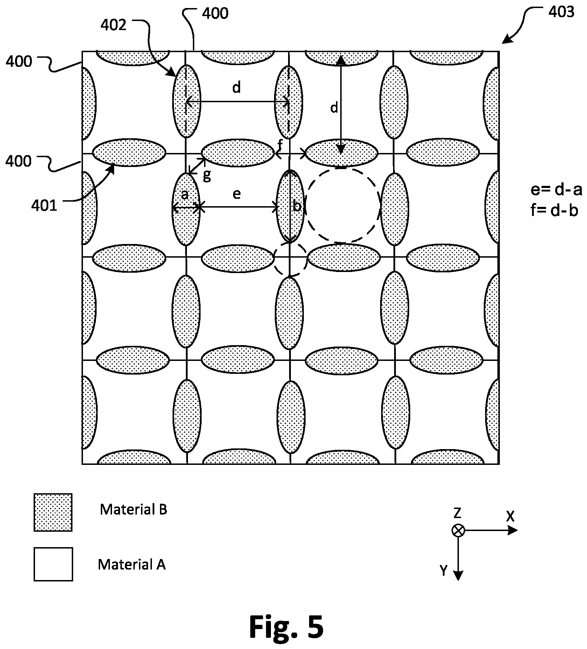

Fig. 5 schematically shows, the nanostructure array with periodic cell structure of Fig. 4 with emphasized dimensions. The nanostructure array 403 comprises structures 401, 402 having a elliptical shape. The nanostructure array 403 is structured as a 4x4 repetition of quadratic cells 404 in the x and y direction, each quadratic cell 404 having a diameter d. That is, the nanostructure cells 404 (i.e. structure cells) have a cell period d. The cell repetition in x-direction and y-directions provides symmetrical properties to the array. Each structure 401, 402 of elliptical shape has two dimensions a, b. Dimension a relates to a smaller diameter of the elliptical shape (i.e. to the minor axis of the ellipse). Dimension b relates to a larger diameter of the elliptical shape (i.e. to the major axis of the ellipse). In Fig. 5 the ratio of dimension a to dimension b is exaggerated to make the difference more visible.

The elliptical structures 401, 402 are positioned such that their axis are colinear with the borders of the cells 404. In other words, the elliptical structures 401, 402 are positioned on the borders of the cells 404, oriented along the x- and y-directions. Each of the nanostructure cells 404 thus comprises half of two vertically positioned structures 402 and half of two horizontally positioned structures 401, such that by two adjacent nanostructure cells 404, a whole structure 401, 402 is formed.

The structures 401, 402 of the nanostructure array 403 change their orientation in each row. In this manner, in one row, dimension a (the minor axis of the ellipse) is parallel to the x-axis (vertically positioned structure 402) and in the next row, dimension a (the minor axis of the ellipse) is parallel to the y-axis (horizontally positioned structure 401). The structures 401, 402 thus include horizontally positioned structures 401 and vertically positioned structures 402.

The distance between the center of two vertically positioned adjacent structures 402 is equal to the cell period d and the distance between two vertically positioned adjacent structures 402 is e, such that e=d-a. The distance in the x-direction between two horizontally positioned adjacent nanostructures 401 is f, such that f=d-b. The distance between one vertically positioned structure 402 and one adjacent horizontally positioned nanostructure 401 is g.

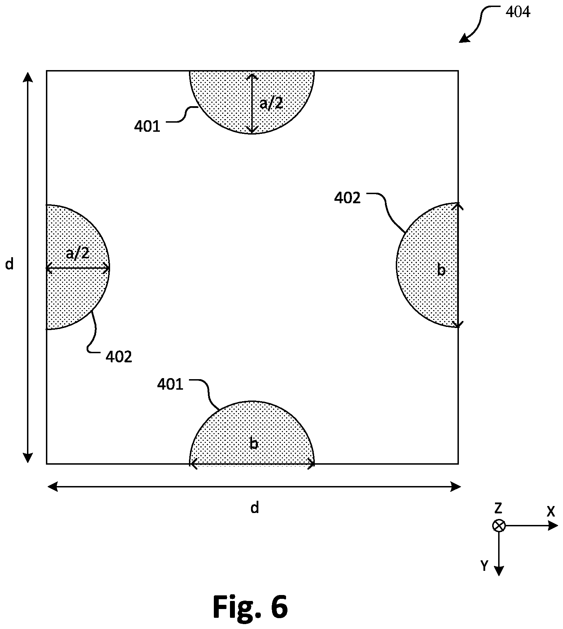

Fig. 6 schematically shows, in a top view of the x-z-plane, a cell of the nanostructure array of Fig. 5 (see 404 in Figs. 4 and 5). The nanostructure cell 404 includes parts of structures 401, 402 (with an elliptical or quasi-circular shape as shown in Figs. 4 and 5 above) having two different dimensions, a and b. The nanostructure cell 404 comprises two halves of two respective vertically positioned structures 402 having a diameter equal to b and a two halves of two respective horizontally positioned nanostructures 401 having a circle radius equal to a/2. The dimension of the nanostructure square cell 404 is equal to d.

Fig. 7 schematically shows a front view of the x-z-plane of the nanostructure cell of Fig. 6. The nanostructure cell 404 has a multilayer structure and comprises two layers 701, 702, where the second layer 702 is arranged below the first layer 701. The cell dimension is equal to d (independent of the pixel pitch). The first layer 701 is made of material A and the second layer 702 is made of material B. Second layer 702 made of material B has a thickness tₐ. In the first layer 701 a structure 402 of thickness t_{b} is embedded (i.e. integrated). The structure 402 is made of material B, i.e. it is of the same material as second layer 702. Inserted structure 402 may for example have an elliptical shape or a quasi-circular shape of the x-z-plane, as described in Figs. 3, 5 and 6 above.

The bottom surface of the inserted structure 402 is located at a distance t¹ from the top of layer 702, and the top surface of the inserted structure 402 is located at a distance t² from the top surface of layer 702. The first layer 701 with the embedded structure 402 together with the second layer 702 form an infrared absorber (see 302 of Fig. 3). The thickness t¹ of the layer between the ellipses and the lower aluminum plate determine the value of the peak absorption.

Embedding a nanostructure cell in layer 701 made of material A, followed by a second layer 702 made of material B may allow for a resonance that absorbs the desire wavelength.

By choosing the configuration appropriately, such a multilayer structure may be tuned to optimize the absorption of a specific infrared bandwidth.

In the embodiment of Fig. 7, the materials used in the original pixels may be used for the infrared absorber. It should however be noted that, in alternative embodiments, an infrared absorber metasurface may be generated using different dielectrics and different metal layers, or two layers of different dielectrics.

Choosing the configuration may for example comprise choosing the dimensions (e.g. a and b) of the nanostructure, and/or using different combinations of material A and B.

For example, a nanostructure may use materials with low contamination probability for a fab and/or easily accessible, a design that allows a simple and cheap fabrication process, and a design very resilient to dimensions variations during fabrication. Such a multilayer structure may be easily integrated above the metallization layer of existing pixel designs (such as the metallization layer 303 of Fig. 3), and also may improve the pixel performance.

### Backside-illuminated pixel with additional FTI or DTI

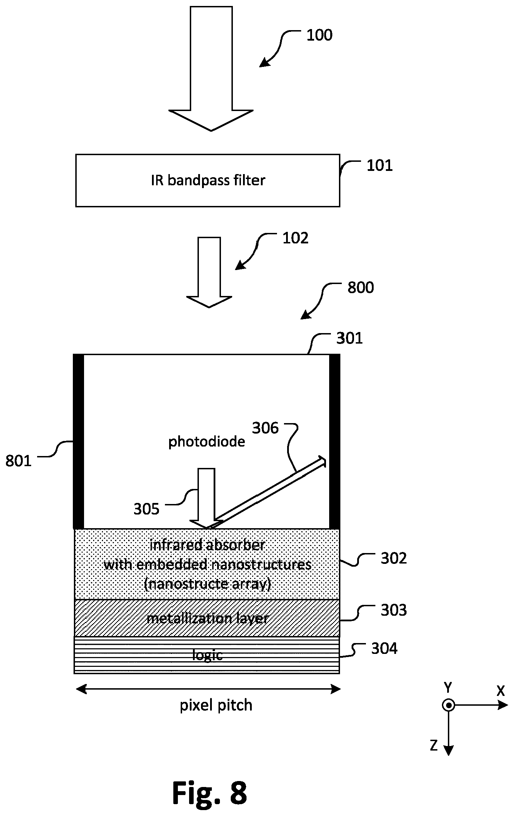

Fig. 8 schematically shows, in a cross-sectional view in the x-z-plane, a backside-illuminated pixel having a metallization layer, an infrared absorbing layer with embedded nanostructure, and a fill trench isolation (FTI) at the border to adjacent pixels. As in the backside-illuminated pixel of Fig. 3, wide spectrum IR light 100 is filtered by an IR bandpass filter 101 to allow only light of a desired wavelength to pass through the IR bandpass filter 101. The filtered light 102 illuminates a backside-illuminated pixel 800. The backside-illuminated pixel 800 comprises a photodiode 301 is provided with a fill trench isolation (FTI) 801. The FTI is included in many pixel designs to reduce the cross-talk, contributing independently to the infrared absorber function. The FTI 801 is formed along two opposite sides of the photodiode 301, and between two adjacent photodiodes, thus, between two adjacent pixels. The FTI 801 is a common barrier added to the pixels that may block the crosstalk and may be independent of the IR absorber. Similar to the backside-illuminated pixel of Fig. 3, the backside-illuminated pixel 800 further comprises an infrared absorber 302 with embedded nanostructures, a metallization layer 303 and a logic 304. The filtered light 102 enters the photodiode 301 and the photodiode 301 converts a part of the filtered light 102 into a photocurrent. The non-converted light 305 in the photodiode 301 impacts in the infrared absorber 302 producing reflections 306. The infrared absorber 302 may comprise an infrared absorber layer including embedded nanostructures having an elliptical shape or quasi-circular shape as shown with regard to Figs. 4 to 7 above. The infrared absorber 302 may thus significantly prevent reflections 306 from entering and being reflected in the metallization layer 303.

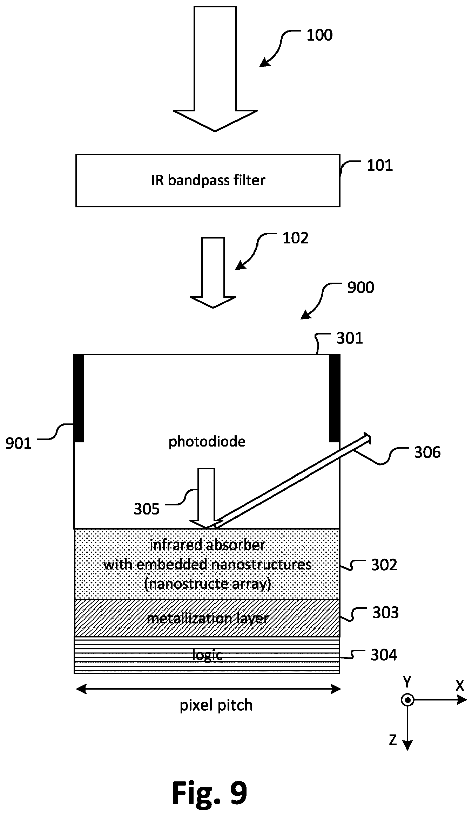

Fig. 9 schematically shows, in a cross-sectional view in the x-z-plane, a backside-illuminated pixel having a metallization layer, an infrared absorbing layer with embedded nanostructure, and a deep trench isolation (DTI) at the border to adjacent pixels. As in the case of Fig. 8, wide spectrum IR light 100 is filtered by an IR bandpass filter 101 to allow only light of a desired wavelength 102 to pass through the IR bandpass filter 101. The filtered light 102 illuminates a backside-illuminated pixel 900. The backside-illuminated pixel 900 comprises a photodiode 301 having a DTI 901. The DTI 801 is formed along two opposite sides of the photodiode 301, and between two adjacent photodiodes, thus, between two adjacent pixels. The DTI 801 is included in many pixel designs to reduce the crosstalk, contributing independently to the infrared absorber function. The DTI 801 is a common barrier added to the pixels that may block the crosstalk and may be independent of the absorber. Similar to the backside-illuminated pixel of Fig. 8, the backside-illuminated pixel 900 further comprises an infrared absorber 302 with embedded nanostructures, a metallization layer 303 and a logic 304.

### Sensor with nanostructure IR absorber, anti-flare and OPB shield

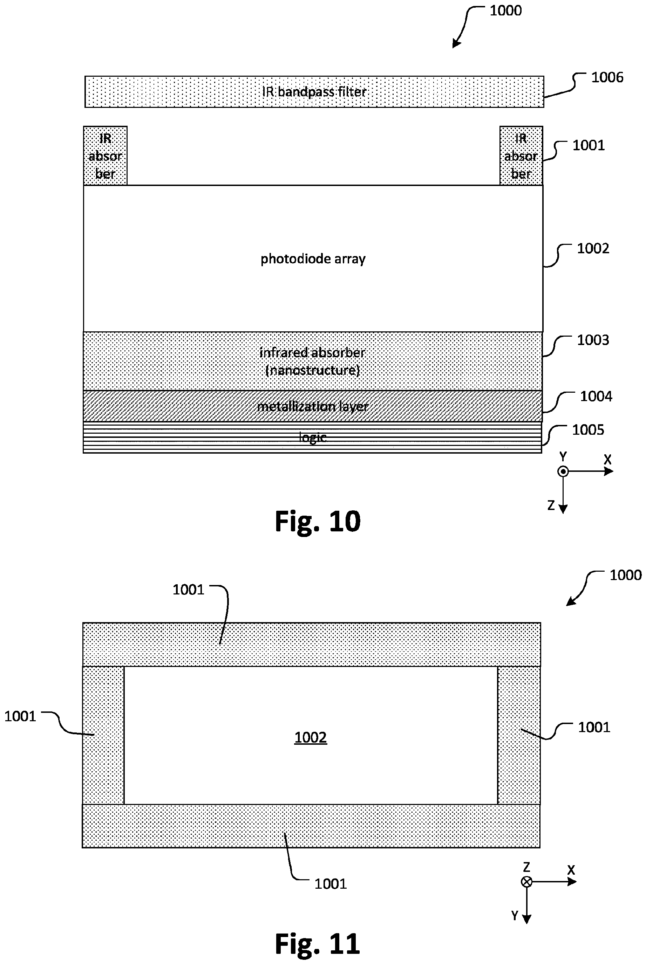

Fig. 10 schematically shows, in a cross-sectional view of the x-z-plane, a structure of a backside-illuminated pixel array with additional IR absorber arranged above the photodiode array. The backside-illuminated pixel array 1000 comprises a plurality of backside-illuminated pixels with nanostructure IR absorber, such as the backside-illuminated pixel described with regard to Figs. 3, 8 and 9 above. In particular, the backside-illuminated pixel array 1000 comprises a photodiode array layer 1002 (see also 301 in Figs. 3, 8, and 9), an infrared absorber layer 1003 (see also 301 in Figs. 3, 8, and 9), a metallization layer 1004 (see also 303 in Figs. 3, 8, and 9), and a logic layer 1005 (see also 304 in Figs. 3, 8, and 9). Above the photodiode array layer 1002, an additional IR absorber 1001 is arranged, having the same multilayer structure as the IR absorber described with regard to Figs. 4, 5, 6 and 7 above. As shown in Fig. 11, this additional IR absorber 1001 only covers the outer region of the backside-illuminated pixel array 1000. An IR bandpass filter 1006 is located above the photodiode array and above the additional IR absorber 1001 (see also 101 in Figs. 3, 8, and 9).

In the embodiment of Fig. 10, the additional IR absorber 1001 on top of the pixel provides the functionalities of an anti-flare shield and an On Pixel Barrier (OPB) shield. The functionality of an anti-flare shield is to prevent undesirable artifacts on an image captured by an imaging sensor, due to a blow of light (flare). Such a blow of light (flare) is generated when a strong incident light hits some areas of the chip of the sensor, which leads to reflections being produced at the surface of the chip that reflects back to the optical stack, creating bouncing light that propagates across the sensor array. The functionality of OPB is to avoid the light to reach unwanted areas of the chip, e.g. in a case where it is desirable to isolate the border of the sensor array from outer chip reflections. Therefore, the additional IR absorber 1001 on top of the pixel has the above described two functionalities, anti-flare (reflections) and OPB shield (transmissions).

Fig. 11 schematically shows, in a top view of the x-z-plane, the structure of a backside-illuminated pixel array of Fig. 10. The top view of the ToF sensor structure (see 1000 in Fig. 10a) shows a backside-illuminated pixel array 1000 formed by a plurality of backside-illuminated pixels. Above a photodiode array layer 1002 formed by the photodiodes of the backside-illuminated pixels, an nanostructure IR absorber layer 1001 is arranged. The nanostructure IR absorber layer 1001 has the same multilayer structure as the IR absorber described with regard to Figs. 4, 5, 6 and 7 above.

### Exemplifying design configurations

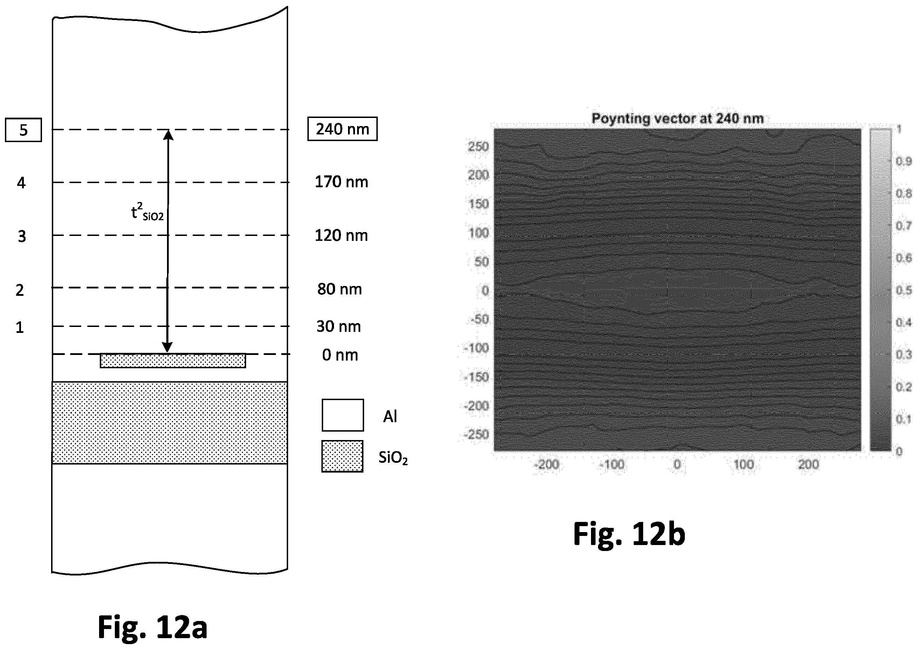

Fig. 12a, 13a, and 14a show three exemplifying configurations of an infrared absorber with an embedded nanostructure optimized for a certain wavelength. In each case, the nanostructure is configured as a nanostructure array with cell period d. The nanostructure array comprises structures with quasi-circular shape are located with changing orientation at the cell borders as shown in Figs. 4 to 7 above. The quasi-circular shape corresponds to an elliptical shape where the two dimensions a (minor axis) and b (major axis) are close to each other. The quasi-circular structures that make up the nanostructure array are made of aluminum. The layer in which the nanostructure is embedded is made of silicon dioxide (SiO₂). The parameters t¹_{SiO2}, tₐₗ, t²_{SiO2}, and t_{d} define the parameters of the layered structure. t¹_{SiO2} (which corresponds to t₂ in Fig. 7) corresponds to the distance between the quasi-circular structures and the bottom surface of the silicon dioxide layer (701 in Fig. 7). t²_{SiO2} (which corresponds to t₁ in Fig. 7) corresponds to distance between the quasi-circular structures and the top surface of the silicon dioxide layer (701 in Fig. 7). t_{d} (which corresponds to t_{b} in Fig. 7) corresponds to thickness of the quasi-circular structures. tₐₗ corresponds to the aluminum layer (702 in Fig. 7) which is located below the silicon dioxide layer (701 in Fig. 7) with embedded nanostructure.

In general, the following dependencies are observed:
- The bigger axis b of the ellipses determines the higher frequency for the absorption peak.
- The smaller axis a of the ellipses determines the lower frequency of the absorption peak.
- The periodicity (cell period d) of the nanostructure array increases the valley between the peaks.
- The thickness t²_{SiO2} of the layer between the ellipses and the lower aluminum plate determine the value of the peak absorption.

Fig. 12a shows an exemplifying configuration of an infrared absorber with an embedded nanostructure optimized for absorption at 940 nm wavelength. The configuration of the nanostructure is as presented in Table 1 below:

**Table 1: parameters of nanostructure optimized for absorption at 940 nm wavelength**

| Nominal dimensions (factor = 0 nm) | |
|---|---|
| a | 182 nm |
| b | 214 nm |
| d | 564 nm |
| t¹_{SiO2} | 50 nm |
| tₐₗ | 60 nm |
| t²_{SiO2} | 240 nm |
| T_{d} | 20 nm |

Fig. 12b shows a contour plot of the relative reflected power density at a transversal-cut surface located at 240 nm (layer no. 5 in the figure 12a) above the inserted nanostructure for the configuration of Fig. 12a (240 nm t²_{SiO2}). The contours show the ratio of the reflected power density in [W/m²] to the incident power density [W/m²], the ratio ranging from 0 to 1.
Reflection = Integral of relative reflected power density = 0.0123 @ #5 (240 nm t²_{SiO2})
Absorption = 1 - Reflection = 0.9877 @ #5 (240 nm t2SiO2)

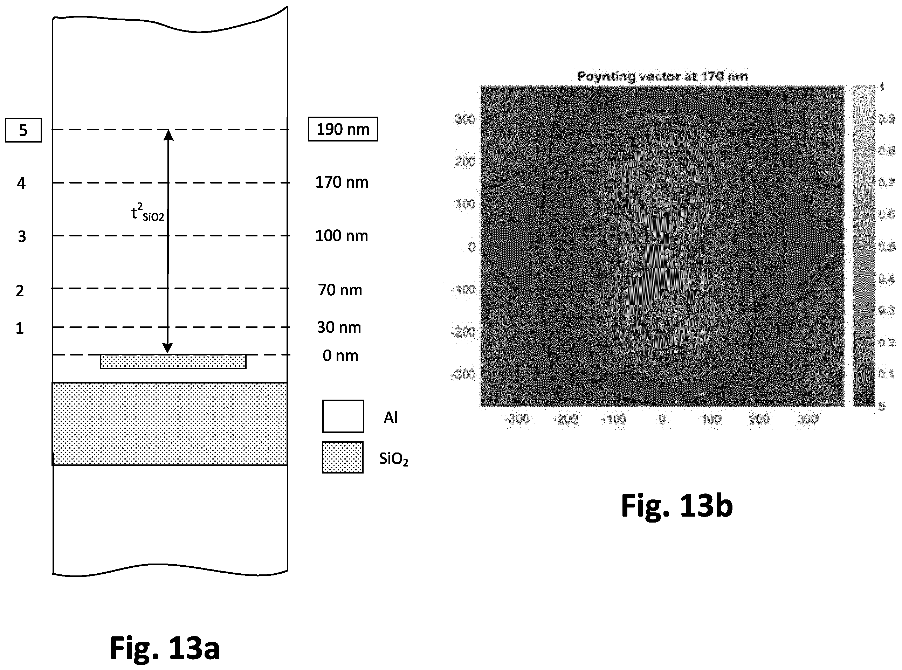

Fig. 13a shows an exemplifying configuration of an infrared absorber with an embedded nanostructure optimized for absorption at 1380 nm wavelength. The configuration of the nanostructure is as presented in Table 2 below:

**Table 2: parameters of nanostructure optimized for absorption at 1380 nm wavelength**

| Nominal dimensions (factor = 0nm) | |
|---|---|
| a | 298 nm |
| b | 333 nm |
| d | 750 nm |
| t¹_{SiO2} | 38 nm |
| tₐₗ | 60 nm |
| t²_{SiO2} | 190 nm |
| T_{d} | 20 nm |

Fig. 13b shows a contour plot of the relative reflected power density at a transversal-cut surface located at 190 nm (layer no. 5 in the figure 13a) above the inserted nanostructure for the configuration of Fig. 13a (190 nm t²_{SiO2}). The contours show the ratio of the reflected power density in [W/m²] to the incident power density [W/m²], the ratio ranging from 0 to 1.
Reflection = Integral of relative reflected power density = 0.0161 @ #5 (190 nm t²_{SiO2})
Absorption = 1 - Reflection = 0.9839 @ #5 (190 nm t²_{SiO2})

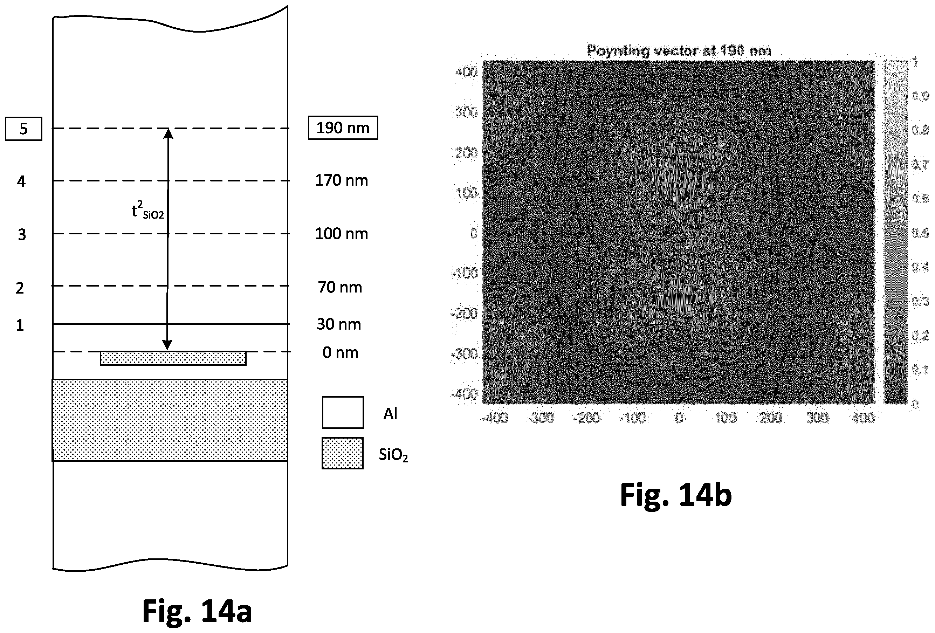

Fig. 14a shows an exemplifying configuration of an infrared absorber with a nanostructure optimized for absorption at 1550 nm wavelength. The configuration of the nanostructure is as presented in Table 3 below:

**Table 3: parameters of nanostructure optimized for absorption at 1550 nm wavelength**

| Nominal dimensions (factor = 0nm) | |
|---|---|
| a | 350 nm |
| b | 390 nm |
| d | 850 nm |
| t¹_{SiO2} | 45 nm |
| tₐₗ | 60 nm |
| t²_{SiO2} | 190 nm |
| T_{d} | 20 nm |

Fig. 14b shows a contour plot of the relative reflected power density at a transversal-cut surface located at 190 nm (layer no. 5 in the figure 14a) above the inserted nanostructure for the configuration of Fig. 14a (190 nm t²_{SiO2}). The contours show the ratio of the reflected power density in [W/m²] to the incident power density [W/m²], the ratio ranging from 0 to 1.
Reflection = Integral of reflected power density = 0.0066 @ #5 (190 nm t²_{SiO2})
Absorption = 1 - Reflection = relative0.9934 @ #5 (190 nm t²_{SiO2})

Fig. 12b, Fig. 13b and Fig. 14b prove that the proposed IR absorber designs have a uniform absorption capability across their area. This uniformity allows to use them independently of the size and/or location of the structures below them, e.g. may allow to choose any pixel size and their location below the IR absorber that all the pixels will be protected against crosstalk similarly.

Table 4 below provides summaries of the designs for the different frequencies. Table 4 provides the nominal geometric design parameters which correspond to a case where a factor representing the design variations is 0nm, i.e. there are no variation from the nominal parameters. In addition, table 4 also provides results for design variations of -10 nm and +10 nm of all the horizontal dimensions simultaneously, i.e. simultaneous variations in the dimensions represented in Fig. 4. The absorption strength (called "power parameter" in Table 4) is provided in the form of a reference integral which is the area over the absorption curve between ±25 nm of the central frequency of the absorber (see Fig. 17). This reference integral corresponds to a square absorption of 2.5 (numerically 2.44). This reference integral represents the energy reflected by the absorber.

**Table 4: Summaries of the designs for the different frequencies**

| | **Error factor** | **940 nm** | **1380 nm** | **1550 nm** |
|---|---|---|---|---|
| Power parameter (integral of non absorbed energy < 2.5) | -10nm | 2.23 | 0.74 | 0.36 |
| | 0nm | 0.66 | 0.45 | 0.27 |
| | 10nm | 0.68 | 0.38 | 0.55 |
| | Average | 1.19 | 0.52 | 0.39 |
| Geometric Parameters (dimensions when design variation is 0 nm) | a | 182 nm | 298 nm | 350 nm |
| | b | 214 nm | 333 nm | 390 nm |
| | d | 564 nm | 750 nm | 850 nm |
| | t¹_{SiO2} | 50 nm | 38 nm | 45 nm |
| | tₐₗ | 60 nm | 60 nm | 60 nm |
| | t²_{SiO2} | 240 nm | 190 nm | 190 nm |
| | t_{d} | 20 nm | 20 nm | 20 nm |
| | g | 200 nm | 214 nm | 230 nm |

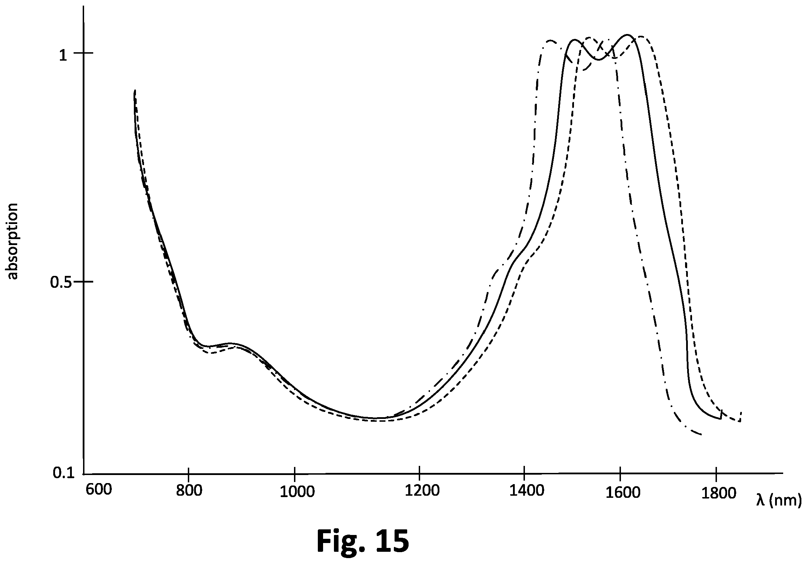

It should be noted that the dimensions variations presented in the tables above are in a 10% range of the horizontal reference dimension, e.g. +-10 nm <= 10% of any reference horizontal dimension. Fig. 15 illustrates in diagram the performance of a nanostructure IR absorber as described in the embodiments above. The abscissa of the diagram represents the wavelength λ in nm of incident light in a range of 600 nm to 1800 nm, and the ordinate represents the absorption of the IR absorber in a range of 0.1 to 1 when incident light of wavelength λ impacts on the IR absorber. The solid curve shows the absorption for the nominal design parameters of Table 4 (factor of 0 nm), a reference integral of 1.4, a center frequency CFA(1) of 1586 nm, absorption A = 0,999 and Width band Minimum Absorption WMA = 137 nm. These parameters quantify the result of the simulation, i.e. how good the absorber is respect to a reference perfect one (square absorption band with absorption above 95%). The dash-dotted curve shows the absorption for a variation factor of -10 nm, an integral of 0.65, a center frequency of CFA(1) of 1556 nm, absorption A = 0,998 and Width band Minimum Absorption WMA = 138 nm. The dotted curve shows the absorption for a variation factor of +10 nm, an integral of 1.12, a center frequency of CFA(1) of 1619 nm, absorption A = 1 and Width band Minimum Absorption WMA = 139 nm.

As can be seen from the in the diagram, the nanostructure IR absorber absorbs above 95% of incident light in a bandwidth of +/- 25 nm, centered in 1380 nm. This performance of the nanostructure IR absorber is maintained even when considering potential variations of the structure during fabrication in +/- 10 nm.

As can be seen from Fig. 12. the design according to the embodiments puts the resonances of the nanostructure close to each other to create a wideband of absorption centered in the wavelength of interest. In this way, the pixel design of the embodiments can reduce the reflected IR of the given band in the metallization.

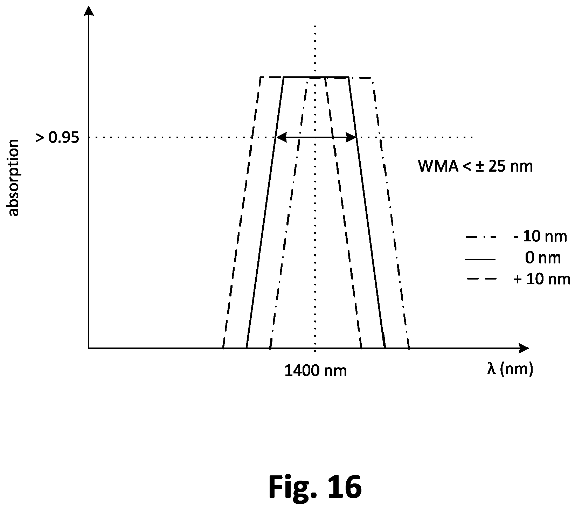

Fig. 16 illustrates in diagram the Width band Minimum Absorption (WMA) as described with regard to Fig. 15 above.

It should be noted that the description above is only an example configuration. Alternative configurations may be implemented with additional or other units, sensors, or the like.

It should also be noted that the division of the systems into units is only made for illustration purposes and that the present disclosure is not limited to any specific division of functions in specific units.

It should also be recognized that the embodiments describe methods with an exemplary ordering of method steps. The specific ordering of method steps is, however, given for illustrative purposes only and should not be construed as binding.

All units and entities described in this specification and claimed in the appended claims can, if not stated otherwise, be implemented as integrated circuit logic, for example, on a chip, in FPGA, or the like, and functionality provided by such units and entities can, if not stated otherwise, be implemented by software.

In so far as the embodiments of the disclosure described above are implemented, at least in part, using software-controlled data processing apparatus, it will be appreciated that a computer program providing such software control and a transmission, storage or other medium by which such a computer program is provided are envisaged as aspects of the present disclosure.

Note that the present technology can also be configured as described below:
[1] A backside-illuminated pixel comprising a photodiode (301) and an infrared absorber (301) with embedded nanostructure (402, 403), wherein the infrared absorber (301) with embedded nanostructure (401, 402) is configured to absorb light (305) that passes the photodiode (301).
[2] The backside-illuminated pixel of [1], wherein the infrared absorber (301) has a multilayer structure comprising a first layer (701) and a second layer (702) arranged below the first layer (701), and wherein the nanostructure (401, 402) is embedded in the first layer (701) of the multilayer structure.
[3] The backside-illuminated pixel of claim [2], wherein the embedded nanostructure (401, 402) in combination with the first and second layers (701, 702) forms a meta-surface with the capability of absorbing light (305).
[4] The backside-illuminated pixel of [2] or [3], wherein the first layer (701) is made of a material A and the second layer (702) is made of a material B different from the material A, and the nanostructure (401, 402) inserted in the first layer (701) is made of the same material as the second layer (702).
[5] The backside-illuminated pixel of [4], wherein the material A is a dielectric, and the material B is a metal.
[6] The backside-illuminated pixel of [5], wherein the material A is silicon dioxide, and the material B is aluminum.
[7] The backside-illuminated pixel of [1] to [6], wherein the embedded nanostructure (401, 402) is configured as a nanostructure array (403) having a pattern that is spatially repeated.
[8] The backside-illuminated pixel of [7], wherein the nanostructure array (403) is structured as a repetition of cells (404).
[9] The backside-illuminated pixel of [8], wherein the cell period (d) of the nanostructure array (403) is independent from pixel pitch.
[10] The backside-illuminated pixel of [8] or [9], wherein the nanostructure array (403) comprises structures (401, 402) that are spatially repeated.
[11] The backside-illuminated pixel of [10], wherein the structures (401, 402) of the nanostructure array (403) are positioned at the borders of cells (404).
[12] The backside-illuminated pixel of [10] or [11], wherein the structures (401, 402) of the nanostructure array (403) change their orientation in each row of the pattern.
[13] The backside-illuminated pixel of any one of [10] to [12], wherein the structures (401, 402) of the nanostructure array (403) comprise horizontally positioned structures (401) and vertically positioned structures (402).
[14] The backside-illuminated pixel of any one of [10] to [13], wherein the structures (401, 402) of the nanostructure array (403) have an elliptical shape or quasi-circular shape.
[15] The backside-illuminated pixel of [14], wherein the elliptical shape or quasi-circular shape is defined by a smaller diameter (a) and a larger diameter (b).
[16] The backside-illuminated pixel of [15], wherein the cell period (d) is in a 10% range around 564 nm, the smaller diameter (a) is in in a 10% range around 182 nm, and the larger diameter (b) is in a 10% range around 214 nm.
[17] The backside-illuminated pixel of [15], wherein the cell period (d) is in a 10% range around 750 nm, the smaller diameter (a) is in a 10% range around 298 nm, and the larger diameter (b) is in in a 10% range around 333 nm.
[18] The backside-illuminated pixel of [15], wherein the cell period (d) is in a 10% range around 850 nm, the smaller diameter (a) is in a 10% range around 350 nm, and the larger diameter (b) is in a 10% range around 390 nm.
[19] The backside-illuminated pixel of any one of [2] to [18], wherein the first layer comprises a first sublayer of a first thickness t¹_{SiO2}, a second sublayer of a thickness t_{d}, and a third sublayer of a first thickness t²_{SiO2}, and the second layer has a thickness of tₐₗ.
[20] The backside-illuminated pixel of [19], wherein the thickness t¹_{SiO2} is in a 10% range around 50 nm, the thickness tₐₗ is in a 10% range around 60 nm, the thickness t²_{SiO2} is in a 10% range around 240 nm, and the thickness t_{d} is in a 10% range around 20 nm.
[21] The backside-illuminated pixel of [19], wherein the thickness t¹_{SiO2} is in a 10% range around 38 nm, the thickness tₐₗ is in a 10% range around 60 nm, the thickness t²_{SiO2} is in a 10% range around 190 nm, and the thickness t_{d} is in a 10% range around 20 nm.
[22] The backside-illuminated pixel of [19], wherein the thickness t¹_{SiO2} is in a 10% range around 45 nm, the thickness tₐₗ is in a 10% range around 60 nm, the thickness t²_{SiO2} is in a 10% range around 190 nm, and the thickness t_{d} is in a 10% range around 20 nm.
[23] The backside-illuminated pixel of any one of [1] to [22], wherein the infrared absorber with nanostructure is located above a metallization layer (303), and wherein the infrared absorber layer (701) with embedded nanostructures (402, 403) prevents light (305) from reaching the metallization layer (303).
[24] The backside-illuminated pixel of any one of [1] to [23], wherein the infrared absorber (301) is configured to absorb light around center wavelengths of 940nm, or 1380nm, or 1550nm.
[25] The backside-illuminated pixel of any one of [1] to [24], wherein the backside-illuminated pixel is provided with a fill trench isolation (FTI) at the border to adjacent pixels.
[26] The backside-illuminated pixel of any one of [1] to [25], wherein the backside-illuminated pixel is provided with a deep trench isolation (DTI) at the border to adjacent pixels.
[27] A sensor device comprising a photodiode array (1002) with multiple backside-illuminated pixels as defined in any one of [1] to [26].
[28] The sensor device of [27], wherein the photodiode array (1002) is provided with an additional IR absorber (1001) arranged above the photodiode array.
[29] The sensor device of [28], wherein the additional IR absorber (1001) arranged above of the photodiode array is configured to provide the functionalities of an anti-flare shield and/or an On Pixel Barrier (OPB) shield.
[30] A camera device comprising the sensor device of any one of [27] to [29].

## Claims

1. A backside-illuminated pixel comprising a photodiode and an infrared absorber with embedded nanostructure, wherein the infrared absorber with embedded nanostructure is configured to absorb light that passes the photodiode.

2. The backside-illuminated pixel of claim 1, wherein the infrared absorber has a multilayer structure comprising a first layer and a second layer arranged below the first layer, and wherein the nanostructure is embedded in the first layer of the multilayer structure.

3. The backside-illuminated pixel of claim 2, wherein the embedded nanostructure in combination with the first and second layers forms a meta-surface with the capability of absorbing light.

4. The backside-illuminated pixel of claim 2 or 3, wherein the first layer is made of a material A and the second layer is made of a material B different from the material A, and the nanostructure inserted in the first layer is made of the same material as the second layer.

5. The backside-illuminated pixel of claim 4, wherein the material A is a dielectric, and the material B is a metal.

6. The backside-illuminated pixel of claim 5, wherein the material A is silicon dioxide, and the material B is aluminum.

7. The backside-illuminated pixel of any one of claims 1 to 6, wherein the nanostructure array is structured as a repetition of cells.

8. The backside-illuminated pixel of claim 7, wherein the cell period of the nanostructure array is independent from pixel pitch.

9. The backside-illuminated pixel of claim 7 or 8, wherein the nanostructure array comprises structures that are spatially repeated, wherein the structures of the nanostructure array are positioned at the borders of cells.

10. The backside-illuminated pixel of any one of claims 1 to 9, wherein the nanostructure array comprises structures that are spatially repeated, wherein the structures of the nanostructure array change their orientation in each row of the pattern.

11. The backside-illuminated pixel of any one of claims 1 to 10, wherein the nanostructure array comprises structures that are spatially repeated, wherein the structures of the nanostructure array comprise horizontally positioned structures and vertically positioned structures.

12. The backside-illuminated pixel of any one of claims 1 to 11, wherein the nanostructure array comprises structures that are spatially repeated, wherein the structures of the nanostructure array have an elliptical shape or quasi-circular shape.

13. The backside-illuminated pixel of any one of claims 1 to 12, wherein the backside-illuminated pixel is provided with a fill trench isolation or a deep trench isolation at the border to adjacent pixels.

14. A sensor device comprising a photodiode array with multiple backside-illuminated pixels as defined in any one of claims 1 to 13.

15. The sensor device of claim 14, wherein the photodiode array is provided with an additional IR absorber arranged above the photodiode array, wherein the additional IR absorber arranged above of the photodiode array is configured to provide the functionalities of an anti-flare shield and/or an On Pixel Barrier shield.
